# DEMANDE DE BREVET EUROPEEN

(11) **EP 4 120 358 A2**
(43) Date de publication de la demande: **18.01.2023**
(21) Numéro de dépôt: 22191603.4
(22) Date de dépôt: 25.10.2013
(51) Int. Cl.: H01L 29/40, H01L 21/02, H01L 29/66, H01L 29/06, H01L 29/41, B82Y 10/00, B82Y 40/00, H01L 33/00, H01L 33/12, H01L 33/20, C30B 29/40, C30B 29/60, C30B 29/16, C30B 29/36, C30B 25/00, C30B 25/18, H01L 33/16, H01L 33/24

(54) **DISPOSITIF ELECTRONIQUE A NANOFIL(S) MUNI D'UNE COUCHE TAMPON EN METAL DE TRANSITION, PROCEDE DE CROISSANCE D'AU MOINS UN NANOFIL, ET PROCEDE DE FABRICATION D'UN DISPOSITIF**

(30) Priorité: 26.10.2012 FR 1260209
(62) Demande divisionnaire de: 13783065.9
(71) Demandeur: Commissariat à l'Energie Atomique et aux Energies Alternatives, 75015 Paris (FR); Aledia, 38130 Échirolles (FR)
(72) Inventeur: HYOT, Bérangère, 38320 EYBENS (FR); AMSTATT, Benoit, 38000 GRENOBLE (FR); ARMAND, Marie-Françoise, 38410 VAULNAVEYS-LE-HAUT (FR); DUPONT, Florian, 38000 GRENOBLE (FR)
(74) Mandataire: Novaimo

(57) **Abrégé**

Le dispositif électronique comprend un substrat (1), au moins un nanofil (2) semi-conducteur et une couche tampon (3) interposée entre le substrat (1) et ledit nanofil (2). La couche tampon (3) est formée au moins en partie par une couche de métal de transition nitruré (9) à partir de laquelle s'étend le nanofil (2), ledit métal de transition nitruré étant choisi parmi : le nitrure de vanadium, le nitrure de chrome, le nitrure de zirconium, le nitrure de niobium, le nitrure de molybdène, le nitrure de hafnium, ou le nitrure de tantale.

## Description

### Domaine technique de l'invention

L'invention concerne le domaine des matériaux semi-conducteurs et plus précisément celui de dispositifs à nanofil(s) semi-conducteurs.

L'invention a pour objet plus particulièrement un dispositif comprenant un substrat, au moins un nanofil semi-conducteur et une couche tampon interposée entre le substrat et ledit nanofil.

### État de la technique

Dans le domaine de la croissance des nanofils, il est connu d'utiliser des couches de nucléation comme l'AIN (nitrure d'aluminium) ou encore le TiN (nitrure de titane). Ces couches peuvent être déposées directement par LPCVD (dépôt chimique en phase vapeur à basse pression) ou par APCVD (dépôt chimique en phase vapeur à pression atmosphérique) comme le décrit le document WO2011/162715.

Ce document WO2011/162715 précise que les nanofils semi-conducteurs ont une croissance qui peut être favorisée si l'orientation cristallographique d'un substrat cristallin permettant la croissance est orientée selon la direction [111] dans une structure cubique face centrée de type « NaCl», ou selon la direction [0001] ou selon l'axe 'c' dans une structure « hexagonale ».

Si le substrat n'est pas correctement orienté, il est possible de déposer une couche de nucléation d'AIN ou de TiN dont la structure cristallographique aura une prédominance d'orientation selon la direction [0001] pour l'AlN qui a une structure hexagonale et selon la direction [111] pour le TiN qui a une structure cfc.

Il résulte de ce qui a été dit ci-dessus que l'orientation cristallographique du support de croissance pour les nanofils est importante. Il convient donc d'optimiser la prédominance dans une direction correcte d'une structure cristallographique pour favoriser la croissance des nanofils à partir de cette structure cristallographique.

Par ailleurs, la couche de nucléation ne doit pas faire obstacle à la polarisation d'une nanodiode électroluminescente à base du nanofil par exemple mise en œuvre par une injection des électrons par le substrat vers le nanofil via la couche de nucléation, le nanofil constituant la partie N de la jonction PN de la nanodiode. Il convient donc de trouver une solution pour laquelle cette polarisation peut être optimisée tout en conservant ou en apportant de nouveaux avantages lors de la croissance des nanofils.

### Objet de l'invention

Le but de la présente invention est de proposer un dispositif dont le nanofil présente une bonne orientation cristallographique et permet avantageusement une polarisation optimisée du nanofil.

On tend vers ce but par un dispositif électronique comprenant un substrat, au moins un nanofil semi-conducteur et une couche tampon interposée entre le substrat et ledit nanofil, la couche tampon étant formée au moins en partie par une couche de métal de transition nitruré à partir de laquelle s'étend le nanofil, ledit métal de transition nitruré étant choisi parmi : le nitrure de vanadium, le nitrure de chrome, le nitrure de zirconium, le nitrure de niobium, le nitrure de molybdène, le nitrure de hafnium, ou le nitrure de tantale, en outre la couche tampon est électriquement conductrice de sorte à permettre un contact électrique entre au moins une partie électriquement conductrice du substrat et le nanofil

Avantageusement, la couche de métal de transition nitruré peut être un composé stoechiométrique métal de transition-azote remplissant les conditions suivantes :
- le composé stoechiométrique présente une proportion de métal de transition comprise entre 50% et inférieure à 100%,
- le composé stoechiométrique présente une structure cristallographique favorable à l'épitaxie du nitrure de gallium, notamment une structure cristallographique cubique face centrée ou hexagonale
- une tolérance ΔN par rapport à la concentration en azote inférieure ou égale à 10%.

Selon une mise en œuvre, le nanofil est en nitrure de gallium.

Selon une réalisation, l'extrémité du nanofil distante du substrat est dopée électriquement selon un premier type, et le dispositif comporte un élément électriquement conducteur dopé d'un second type disposé au niveau de l'extrémité du nanofil distante du substrat de sorte à former une jonction électrique, notamment une jonction de diode électroluminescente.

Selon un perfectionnement, le dispositif comporte des puits quantiques disposés au niveau de l'interface entre le nanofil et l'élément électriquement conducteur dopé.

En outre, le dispositif peut comporter un élément de polarisation du nanofil de sorte à permettre la génération d'une onde lumineuse au niveau dudit nanofil.

L'invention est aussi relative à un procédé de croissance d'au moins un nanofil semi-conducteur comportant une étape de réalisation, au niveau d'un substrat, d'une couche tampon formée au moins en partie par une couche de nucléation pour la croissance du nanofil et une étape de croissance du nanofil à partir de la couche de nucléation, la couche de nucléation étant formée par une couche de métal de transition nitruré choisi parmi : le nitrure de vanadium, le nitrure de chrome, le nitrure de zirconium, le nitrure de niobium, le nitrure de molybdène, le nitrure de hafnium, ou le nitrure de tantale. Par ailleurs, en outre la couche tampon peut être électriquement conductrice de sorte à permettre un contact électrique entre au moins une partie électriquement conductrice du substrat et le nanofil.

Selon un premier mode de réalisation, la couche tampon est déposée en phase vapeur à partir d'un mélange gazeux comprenant de l'azote et un métal de transition choisi parmi le vanadium, le chrome, le zirconium, le niobium, le molybdène, le hafnium, ou le tantale, notamment le dépôt de la couche tampon est réalisé à une température comprise entre la température ambiante et 400°C.

Selon un deuxième mode de réalisation, la couche tampon est réalisée à partir des étapes suivantes : le dépôt sur le substrat d'une couche d'un métal de transition choisi parmi le vanadium, le chrome, le zirconium, le niobium, le molybdène, le hafnium, ou le tantale ; la nitruration d'au moins une partie de la couche de métal de transition déposée de sorte à former la couche de métal de transition nitruré présentant une surface destinée à la croissance du nanofil, notamment le dépôt de la couche de métal de transition est réalisé à une température comprise entre la température ambiante et 400°C

Avantageusement et de manière applicable au procédé en général, la couche de métal de transition nitruré est réalisée de sorte à former un composé stoechiométrique métal de transition-azote remplissant les conditions suivantes :
- le composé stoechiométrique présente une proportion de métal de transition comprise entre 50% et inférieure à 100%,
- le composé stoechiométrique présente une structure cristallographique favorable à l'épitaxie du GaN, notamment une structure cristallographique cubique face centrée ou hexagonale
- une tolérance ΔN par rapport à la concentration en azote inférieure ou égale à 10%.

Selon une réalisation applicable au deuxième mode de réalisation, l'étape de nitruration de ladite au moins une partie de la couche de métal de transition est réalisée de sorte à modifier au moins en partie la structure cristallographique de la couche de métal de transition vers une structure cristallographique cubique face centrée, ou hexagonale, associée à la couche de métal de transition nitruré.

Avantageusement, l'étape de nitruration comporte : une première sous-étape de nitruration réalisée au moins en partie à une première température en imposant une injection d'un gaz de nitruration selon un premier débit ; une deuxième sous-étape de nitruration réalisée au moins en partie à une deuxième température inférieure ou égale à la première température en imposant une injection du gaz de nitruration selon un deuxième débit distinct (ou non) du premier débit.

Selon un exemple particulier, le gaz de nitruration injecté est de l'ammoniac, et la première température est comprise entre 1000°C et 1050°C, notamment égale à 1050°C ; le premier débit est compris entre 500*V/8 sccm et 2500*V/8 sccm, notamment égal à 1600*V/8 sccm ; la deuxième température est comprise entre 950°C et 1050°C, notamment égale à 1000°C ; le deuxième débit est compris entre 500*V/8 sccm et 2500*V/8 sccm, notamment égal à 500*V/8 sccm ; où V est la capacité totale en litre d'une enceinte de nitruration correspondante.

Alternativement, l'étape de nitruration comporte une première sous-étape de nitruration réalisée au moins en partie à une première température en imposant une injection d'un gaz de nitruration selon un premier débit, une deuxième sous-étape de nitruration En2 réalisée au moins en partie à une deuxième température supérieure ou égale à la première température en imposant une injection du gaz de nitruration selon un deuxième débit distinct, ou non, du premier débit.

De manière générale, on peut considérer que la première température peut être inférieure ou supérieure ou égale à la deuxième température, et de préférence inférieure ou supérieure à la deuxième température.

De préférence, l'étape de nitruration est réalisée dans une enceinte de nitruration placée à une pression comprise entre 50 mbar et 800 mbar, notamment 100 mbar.

Par exemple, l'étape de croissance du nanofil est réalisée après la deuxième sous-étape de nitruration, ou est initiée au cours de la deuxième sous-étape de nitruration.

Avantageusement, l'étape de croissance du nanofil comporte une étape d'injection de Ga de sorte à former le nanofil en nitrure de gallium, ledit nanofil s'étendant à partir d'une surface de croissance de la couche de nucléation.

Selon une réalisation, le substrat étant en silicium, l'étape de dépôt de la couche de métal de transition est configurée de sorte que l'interdiffusion du silicium dans la couche de métal de transition déposée soit inférieure à 10 nm et/ou de sorte à conserver une tranche de la couche de métal de transition non siliciurée d'au moins 2 nm.

Si le métal de transition déposé est choisi parmi Cr ou V, ledit métal de transition est préférentiellement déposé à une température inférieure à 100°C.

Dans le cas où le substrat 1 est à base de silicium, l'étape de dépôt de la couche de métal de transition 6 comprend préférentiellement une étape préalable de détermination de l'épaisseur de la couche de métal de transition à déposer comprenant : une étape de détermination d'une première longueur de diffusion du silicium dans la couche de métal de transition au cours du futur dépôt de la couche de métal de transition en fonction du métal de transition utilisé et de la température de dépôt ; une étape de détermination d'une deuxième longueur de diffusion du silicium dans la couche de métal de transition au cours de la future étape de nitruration de la couche de métal de transition ; ladite épaisseur de la couche de métal de transition à déposer étant fonction de l'épaisseur désirée de la couche de métal de transition nitruré et d'une épaisseur d'une tranche de métal de transition siliciuré obtenue dans la future couche de métal de transition à partir des première et deuxième longueurs de diffusion déterminées.

Selon une réalisation, le procédé peut comporter une étape dans laquelle on prévoit le substrat de sorte que ce dernier présente une résistivité comprise entre 1 mΩ.cm et 100 mΩ.cm.

De préférence, le procédé comporte avant dépôt de la couche de métal de transition une étape de désoxydation d'une surface du substrat destinée à recevoir la couche de métal de transition.

L'invention est aussi relative à un procédé de fabrication d'un dispositif tel que décrit comportant une étape de mise en œuvre du procédé de croissance tel que décrit.

Le procédé de fabrication peut avantageusement comporter les étapes suivantes : le dopage électrique d'un premier type d'au moins une extrémité du nanofil opposée au substrat ; la formation d'un élément dopé électriquement d'un deuxième type opposé au premier type au niveau de l'extrémité du nanofil opposée au substrat.

En outre, le procédé de fabrication peut comporter une étape de formation de puits quantiques disposés au niveau de l'interface entre le nanofil et l'élément dopé électriquement du deuxième type.

### Description sommaire des dessins

D'autres avantages et caractéristiques ressortiront plus clairement de la description qui va suivre de modes particuliers de réalisation de l'invention donnés à titre d'exemples non limitatifs et représentés sur les dessins annexés, dans lesquels :
- la figure 1 illustre un mode de réalisation particulier d'un dispositif électronique selon l'invention,
- la figure 2 est une vue en coupe d'une étape de formation d'une couche de nucléation,
- la figure 3 est une vue en coupe d'une étape de nucléation d'au moins un nanofil à partir de la couche de nucléation,
- la figure 4 illustre une représentation du spectre de diffraction des rayons X permettant d'identifier les types de structures cristallographiques présentes dans une couche de métal de transition à base de Nb avant nitruration et après nitruration,
- la figure 5 illustre une représentation du spectre de diffraction des rayons X permettant d'identifier les types de structures cristallographiques présentes dans une couche de métal de transition à base de Hf avant nitruration et après nitruration,
- la figure 6 représente en détails une réalisation d'une étape de nitruration selon une mise en œuvre de l'invention,
- les figures 7 et 8 illustrent différentes étapes permettant de mener à la réalisation d'une couche de nucléation,
- la figure 9 illustre en détails une autre réalisation d'une étape de nitruration selon une mise en œuvre de l'invention.

### Description de modes préférentiels de l'invention

Le dispositif décrit ci-après diffère de l'art antérieur notamment par les matériaux utilisés et intercalés entre le nanofil et le substrat.

Le terme 'microfil' ou 'nanofil' dans la suite de la description, signifie préférentiellement une structure tridimensionnelle de forme allongée dont la dimension longitudinale est au moins égale à une fois la ou les dimensions transversales, de préférence au moins cinq fois et encore plus préférentiellement au moins dix fois. La ou les dimensions transversales sont comprises entre 5 nm et 2,5 µm. Dans certains modes de réalisation, les dimensions transversales peuvent être inférieures ou égales à environ 1 µm, de préférence comprises entre 100 nm et 300 nm. Dans certains modes de réalisation, la hauteur de chaque nanofil peut être supérieure ou égale à 500 nm, de préférence comprise entre 1 µm et 50 µm.

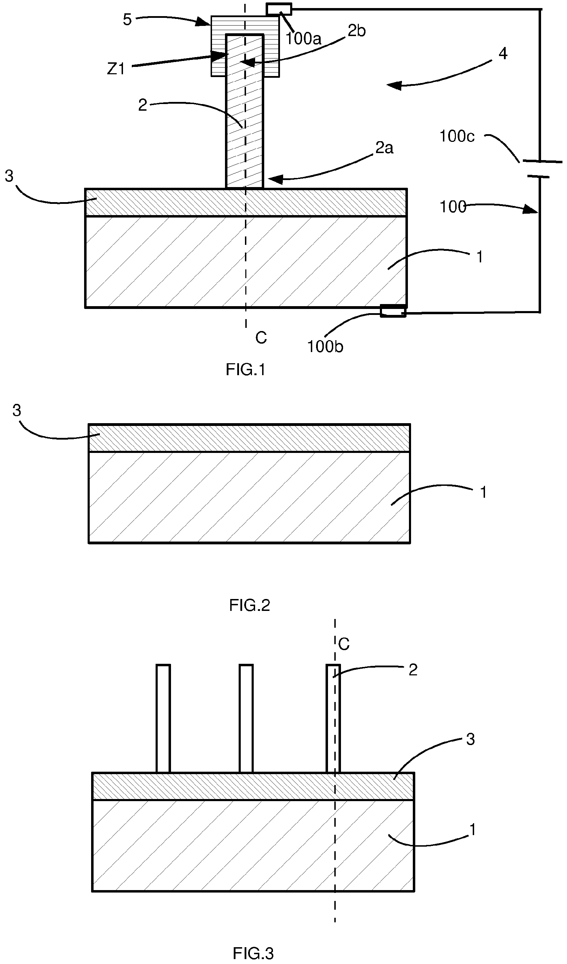

Comme illustré sur la figure 1, le dispositif électronique 4 comprend un substrat 1, au moins un nanofil semi-conducteur 2 et une couche tampon 3 interposée entre le substrat 1 et ledit nanofil 2. La couche tampon 3 est formée au moins en partie par une couche de métal de transition nitruré à partir de laquelle s'étend le nanofil 2, ledit métal de transition nitruré étant choisi parmi : le nitrure de vanadium, le nitrure de chrome, le nitrure de zirconium, le nitrure de niobium, le nitrure de molybdène, le nitrure de hafnium, ou le nitrure de tantale. Par « s'étend », on entend que le nanofil 2 présente une longueur définie entre deux extrémités longitudinales 2a, 2b, une première extrémité longitudinale 2a étant en contact avec la couche de métal de transition nitruré et une deuxième extrémité longitudinale 2b étant distante de la couche de métal de transition nitruré. De préférence, la deuxième extrémité longitudinale 2b est distale de la couche de métal de transition nitrurée.

Le choix de cette couche de métal de transition nitruré permet de conférer à ladite couche de métal de transition nitruré un caractère de conduction électrique de type métallique et un caractère réfractaire de type céramique. Ces propriétés (métallique/réfractaire) a priori antagonistes peuvent être atteintes par les métaux de transitions nitrurés cités ci-dessus. En fait, le caractère réfractaire peut être atteint par un matériau dont le point de fusion est associé à une température supérieure à environ 1800°C, ce qui est le cas pour le nitrure des métaux de transition visés ci-dessus. En outre, une telle couche de métal de transition nitruré a pu servir avantageusement de couche de nucléation lors d'une croissance du nanofil de sorte à obtenir un nanofil orienté selon l'axe C sensiblement perpendiculaire au substrat 1. Par « sensiblement perpendiculaire », on entend exactement perpendiculaire ou perpendiculaire à plus ou moins 10 degrés. Cette légère désorientation de plus ou moins 10 degrés autorise tout de même la réalisation d'étapes technologiques ultérieures permettant de réaliser des dispositifs plus complets.

Le tungstène pourtant présent dans la même colonne de la classification de Mendeleïev que le chrome et le molybdène est écarté de la liste car il présente des caractéristiques insuffisantes de stabilité aux hautes températures, ce qui ne permet pas une croissance efficace des nanofils.

Autrement dit, un tel dispositif 4 ne peut pas être obtenu, ou sera fortement défaillant, si la couche de métal de transition nitruré est à base de tungstène.

Par ailleurs, le nitrure de titane est aussi écarté car lors de son dépôt, ce dernier engendre des défauts dans la structure de la couche ne permettant pas une croissance optimale de nanofil(s). Ainsi, le dispositif 4 aurait des probabilités plus importantes d'être défaillant.

En particulier, la couche de métal de transition nitruré peut être un composé stoechiométrique métal de transition-azote remplissant les conditions suivantes :
- le composé stoechiométrique présente une proportion de métal de transition comprise entre 50% et inférieure à 100%,
- le composé stoechiométrique présente une structure cristallographique favorable à l'épitaxie du nitrure de gallium, notamment une structure cristallographique cubique face centrée ou hexagonale,
- une tolérance ΔN par rapport à la concentration en azote inférieure ou égale à 10% (c'est-à-dire que la différence entre la concentration minimum en azote et la concentration maximum en azote du composé stoechiométrique est inférieure ou égale à 10%, cette valeur étant aussi appelée dans le domaine écart à la stoechiométrie), cette tolérance permet d'assurer la stabilité chimique et thermique du composé stoechiométrique.

Pour les composés à base de Zr, les composés envisagés sont le mononitrure ZrN de structure cfc avec une concentration en N comprise entre 40% et 50%.

Pour les composés à base de Hf, les composés envisagés sont Hf₃N₂ (concentration en azote de 40%) de structure hexagonale ainsi que HfN (avec une concentration en N comprise entre 42,8% et 52,8%) de structure cfc.

Pour les composés à base de V, les composés envisagés sont V₂N (concentration en azote comprise entre 27% et 32%) de structure hexagonale ainsi que VN (avec une concentration en N comprise entre 41,9% et 50%) de structure cfc.

Pour les composés à base de Nb, les composés envisagés sont Nb₂N (concentration en azote comprise entre 30% et 34%) de structure hexagonale, Nb₄N₃ (avec une concentration en N comprise entre 42% et 45%) de structure hexagonale, ainsi que NbN (concentration en azote comprise entre 48% et 51,4%) de structure hexagonale ou cfc.

Pour les composés à base de Ta, les composés envisagés sont Ta₂N (concentration en azote comprise entre 25% et 33%) de structure hexagonale ainsi que TaN (avec une concentration en N comprise entre 48% et 50%) de structure hexagonale ou cfc.

Pour les composés à base de Cr, les composés envisagés sont Cr2N de structure hexagonale ainsi que CrN de structure hexagonale.

Pour les composés à base de Mo, les composés envisagés sont Mo₂N de structure hexagonale ainsi que MoN de structure hexagonale ou cfc.

Pour les mononitrures, dont la concentration en métal est proche de 50%, il est possible de faire varier dans une certaine mesure la concentration en azote tout en conservant un état stable du composé, cette variation est noté ΔN (correspondant à la plage inférieure ou égale à 10% visée ci-dessus). Si ΔN est trop grand la structure associée peut être considérée comme défectueuse. Ceci est dû au fait que de manière générale, une structure de mononitrure est constituée de deux sous-réseaux : les atomes de métal occupent un premier sous-réseau d'orientation cubique face centrée et les atomes d'azote occupent tout ou partie (notamment en fonction de la composition) des sites octaédriques du réseau métallique pour former un deuxième sous-réseau cubique face centré mais décalé, notamment décalé de a/2, « a » représentant le paramètre de maille de la structure cfc. Dans le cas particulier du nitrure de titane, la composition à l'état stable peut être comprise entre Ti₁N_{0.6} et Ti₁N_{1.1} (ou en concentration de N de 37,5% à 52,4% soit un ΔN de 15%). Cette importance de ΔN signifie que pour Ti₁N_{0.6} le sous-réseau d'azote est lacunaire et que pour Ti₁N_{1.1} le sous-réseau métallique est lacunaire. A titre de comparaison : pour le nitrure de vanadium la concentration de N à l'état stable varie entre 41,9% et 50% soit un ΔN de 8,1% ; pour le nitrure de niobium la concentration de N à l'état stable varie entre 48% et 51,4% soit un ΔN de 3,4% ; pour le nitrure de tantale la concentration de N à l'état stable varie entre 48% et 50% soit un ΔN de 2% ; pour le nitrure de chrome la concentration de N à l'état stable varie entre 49,5% et 50% soit un ΔN de 0,5% ; pour le nitrure de molybdène la concentration de N à l'état stable varie entre 29% et 35,4% soit un ΔN de 6,4% ; pour le nitrure de hafnium la concentration à l'état stable varie entre 42,8% et 52,8% soit un ΔN de 10% ; pour le nitrure de zirconium la concentration à l'état stable varie entre 40% et 50% soit un ΔN de 10%.

Avantageusement, le ou les nanofils 2 sont en nitrure de gallium. Le nitrure de gallium est un bon candidat pour former un dispositif opto-électronique. En effet, un tel nanofil 2 en nitrure de gallium permet de former un nano-émetteur de lumière. Des puits quantiques à base de GaN peuvent être ajoutés soit sous forme de coquille autour du nanofil, soit dans la continuité de l'axe du nanofil (structure axiale). Suivant la composition de ces puits quantiques à base de GaN, le domaine spectral de l'émission de lumière pourra couvrir une large gamme de longueur d'onde allant de l'ultra-violet à l'infra-rouge.

De préférence, la couche tampon 3 est électriquement conductrice de sorte à permettre un contact électrique entre au moins une partie électriquement conductrice du substrat 1 et le nanofil 2. Le substrat 1 dans son intégralité peut aussi être électriquement conducteur, il peut alors par exemple être en silicium dopé n.

Selon une mise en œuvre particulière, l'extrémité 2b du nanofil 2 distante du substrat 1 est dopée électriquement selon un premier type (par exemple de type n), et le dispositif comporte un élément 5 électriquement conducteur dopé d'un second type (par exemple de type p) disposé au niveau de l'extrémité 2b du nanofil 2 distante du substrat 1 de sorte à former une jonction électrique. Cette fonction électrique est préférentiellement une jonction de diode électroluminescente. L'élément 5 dopé de sorte à former une jonction avec l'extrémité 2b du nanofil 2 peut recouvrir au moins en partie le nanofil 2 au niveau de ladite extrémité 2b. De préférence, l'élément 5 dopé forme un fourreau autour de l'extrémité 2b du nanofil 2.

De manière préférentielle, le dispositif 4 comporte des puits quantiques (non représentés) disposés au niveau de l'interface entre le nanofil 2 et l'élément 5 électriquement conducteur dopé.

Le dispositif peut comporter un élément de polarisation 100 du nanofil 2 de sorte à permettre la génération d'une onde lumineuse au niveau dudit nanofil. On comprend donc que le dispositif peut être un dispositif opto-électronique. Un élément de polarisation comporte les moyens nécessaires pour générer un courant traversant le dispositif. Sur l'exemple particulier de la figure 1, l'élément de polarisation 100 peut comporter un premier contact électrique 100a en contact direct avec l'élément 5 électriquement conducteur dopé, un deuxième contact électrique 100b en contact direct avec le substrat 1 et une source d'énergie 100c. Ceci permet, par exemple, d'injecter des électrons et des trous de sorte à provoquer leurs recombinaisons dans une zone Z1 du nanofil 2.

Par ailleurs, dans le cadre d'un dispositif opto-électronique, les puits quantiques peuvent former, le cas échéant, des zones de confinement afin d'augmenter le rendement d'émission du nanofil 2.

Il a été donné un exemple à base d'un nanofil 2, bien entendu, le dispositif 4 peut comporter une pluralité de nanofils s'étendant de la couche de métal nitruré de sorte à former par exemple une matrice de pixels. Les éléments 5 peuvent alors tous être reliés électriquement entre eux.

Le dispositif décrit ci-avant peut avantageusement être réalisé au moins en partie à partir du procédé décrit ci-après.

De manière générale, sur les figures 2 et 3, le procédé de croissance d'au moins un nanofil 2 semi-conducteur comporte une étape de réalisation, au niveau du substrat 1, de la couche tampon 3 (figure 2) formée au moins en partie par une couche de nucléation pour la croissance du nanofil 2 et une étape de croissance du nanofil 2 (figure 3) à partir de la couche de nucléation. Sur l'exemple des figures 2 et 3, la couche tampon 3 est constituée par la couche de nucléation. En particulier, la couche de nucléation est formée par une couche d'un métal de transition nitruré choisi parmi : le nitrure de vanadium, le nitrure de chrome, le nitrure de zirconium, le nitrure de niobium, le nitrure de molybdène, le nitrure de hafnium, ou le nitrure de tantale. Autrement dit, on peut aussi considérer que la couche de nucléation est constituée par une couche de métal de transition nitruré telle que décrite. Afin d'optimiser la croissance, cette couche de nucléation/métal de transition nitrurée peut avoir une épaisseur minimale de 2nm, et de préférence comprise entre 2 nm et 50 nm.

En outre, comme évoqué ci-dessus la réalisation de la couche tampon peut être telle qu'elle soit électriquement conductrice de sorte à permettre un contact électrique entre au moins une partie électriquement conductrice du substrat et ledit au moins un nanofil

Cette couche tampon 3 peut être réalisée à partir de tout type de technique de dépôt. La couche de métal de transition nitruré (c'est-à-dire la couche de nucléation) ainsi obtenue permet, en outre, grâce au métal de transition utilisé, de présenter un gap plus faible que les couches de nucléation à base d'AIN très utilisées à ce jour comme couche de nucléation. Ainsi, lorsque le substrat 1 est à base de silicium, la couche tampon 3 selon l'invention présente à son interface avec le substrat 1 une barrière de potentiel plus facilement franchissable que dans le cas où on utilise de l'AlN, ceci conférant un avantage lorsque l'on souhaite polariser un ou plusieurs nanofils à partir du substrat 1.

Selon un premier mode de réalisation la couche tampon 3 est déposée en phase vapeur à partir d'un mélange gazeux comprenant de l'azote et un métal de transition choisi parmi le vanadium, le chrome, le zirconium, le niobium, le molybdène, le hafnium, ou le tantale notamment le dépôt de la couche tampon 3 est réalisé à une température comprise entre la température ambiante et 400°C. On obtient ainsi, après ce dépôt, directement la couche de nucléation. Selon ce premier mode de réalisation, la couche tampon 3 peut être constituée par la couche de nucléation, elle-même constituée par la couche de métal de transition nitruré.

Selon un deuxième mode de réalisation, la couche tampon 3 est réalisée à partir des étapes suivantes : le dépôt sur le substrat 1 d'une couche d'un métal de transition choisi parmi le vanadium, le chrome, le zirconium, le niobium, le molybdène, le hafnium, ou le tantale ; et la nitruration d'au moins une partie de la couche de métal de transition déposée de sorte à former la couche de métal de transition nitruré présentant une surface destinée à la croissance du ou des nanofils. De préférence, le dépôt de la couche de métal de transition est réalisé à une température comprise entre la température ambiante et 400°C Selon une mise en œuvre applicable aux différents métaux de transition, notamment pour Hf, Nb, Ta, la couche déposée de métal de transition peut présenter une épaisseur comprise entre 20 nm et quelques centaines de nanomètres (par exemple 200 nm). Pour les autres métaux de transition, on préférera une épaisseur de 20 nm. Le dépôt de la couche de métal de transition peut être réalisé par PVD (dépôt physique par phase vapeur) à partir d'une cible métallique, par exemple une pulvérisation à courant continu parcourant la cible. Au cours de cette étape de dépôt du métal de transition, le substrat peut être maintenu à température ambiante. De manière générale applicable à toute la description par « température ambiante », on entend une température de préférence comprise entre 20°C et 50°C. La pression dans l'enceinte PVD durant le dépôt du métal de transition peut être comprise entre 3.10⁻³ mbar et 6.10⁻³ mbar.

Après différents tests, il a été possible d'observer que la croissance du ou des nanofils était favorisée par cette couche de nucléation formée en deux étapes, on comprend donc que ce deuxième mode est préféré.

Comme indiqué précédemment dans la description particulière du dispositif, et de manière applicable aux différentes réalisations du procédé de croissance, la couche de métal de transition nitruré peut être le composé stoechiométrique métal de transition-azote remplissant les conditions précédemment évoquées.

Il a été donné un exemple se basant sur la croissance d'un nanofil, cependant le procédé de croissance n'est pas limité à ce seul exemple et permet, lors de l'étape de croissance, de faire croître une pluralité de nanofils côte-à-côte à partir de la couche de nucléation.

On comprend de ce qui a été dit, que la couche de nucléation a comme fonction de favoriser la nucléation du ou des nanofils. En outre, cette couche de nucléation est préférentiellement choisie de sorte à protéger le substrat 1 d'une éventuelle dégradation lors de la croissance (ce qui peut être le cas si le substrat est en silicium et le nanofil en nitrure de gallium), et/ou à conserver une bonne stabilité aux hautes températures (cas des températures supérieures à 500°C), et/ou à conférer une bonne conduction électrique notamment lorsque l'on souhaite polariser chaque nanofil et injecter du courant par le substrat 1. Les matériaux de la couche de nucléation visée ci-avant permettent de répondre à ces problématiques.

Concernant le substrat 1, le procédé peut, de manière non limitative, comporter une étape dans laquelle on prévoit le substrat de sorte que ce dernier présente une résistivité comprise entre 1 mΩ.cm et 100 mΩ.cm. Cette résistivité présente un intérêt lorsque l'on souhaite polariser les nanofils comme indiqué ci-dessus au travers de la couche de nucléation par l'intermédiaire du substrat 1.

Afin d'optimiser la croissance du ou des nanofils, on va donc rechercher à avoir, au niveau de la couche de nucléation, une orientation cristallographique adaptée pour la croissance des nanofils 2. Plus cette orientation cristallographique sera dense, c'est-à-dire prédominante, plus la densité de ces nanofils 2 peut être magnifiée.

De manière générale, l'étape de croissance dudit au moins un nanofil 2 peut comporter une étape d'injection d'un matériau destiné à former au moins en partie le nanofil 2. En particulier, il s'agira d'une injection de Ga de sorte à former le nanofil en nitrure de gallium, ledit nanofil s'étendant à partir de la surface de croissance de la couche de nucléation. Pour former le nanofil 2 en nitrure de gallium, l'injection de Ga pourra être réalisée concomitamment avec une injection de NH₃ ou de N₂. En général pour la synthèse de GaN, c'est la réaction du Ga avec le NH3 et non avec le N₂ qui est utilisée. L'injection de Ga peut être réalisée dans une enceinte adaptée à la croissance de nanofils.

La description ci-après s'applique au deuxième mode de réalisation du procédé de croissance, c'est-à-dire à la couche de métal nitruré obtenue en deux étapes.

Dans le cadre du deuxième mode de réalisation du procédé de croissance, il s'avère que la couche de métal nitruré ainsi formée présente des sites de croissance dont l'orientation cristallographique est plus propice à la croissance des nanofils que dans le premier mode. Ces sites de croissance sont en plus grand nombre et présentent une meilleure répartition que dans le premier mode.

Il résulte de ce qui a été dit précédemment que l'orientation cristallographique de la couche de nucléation, notamment au niveau d'une surface destinée à la croissance du ou des nanofils, revêt une importance dans le cadre de la favorisation de la croissance des nanofils.

Ainsi, l'étape de dépôt de la couche de métal de transition est préférentiellement réalisée de sorte à ce que ladite couche de métal de transition présente, avant l'étape de nitruration, au moins en partie une structure cristallographique de type cubique centrée (CC) pour une couche de métal de transition choisi parmi Cr, Mo, V, Nb, Ta, ou hexagonale pour une couche de métal de transition choisi parmi Zr et Hf.

Les orientations spécifiques visées précédemment permettent de réaliser l'étape de nitruration de ladite au moins une partie de la couche de métal de transition de sorte à modifier au moins en partie la structure cristallographique de la couche de métal de transition vers une structure cubique face centrée, notamment orientée [111], ou hexagonale, notamment orientée [0001] ou selon la direction d'axe 'C', associée à la couche de métal de transition nitruré. Les métaux de transition des colonnes 4 et 6 forment préférentiellement des nitrures ayant une structure cristallographique cfc alors que les métaux de transition de la colonne 5 peuvent former des nitrures ayant une structure cristallographique cfc ou hexagonale.

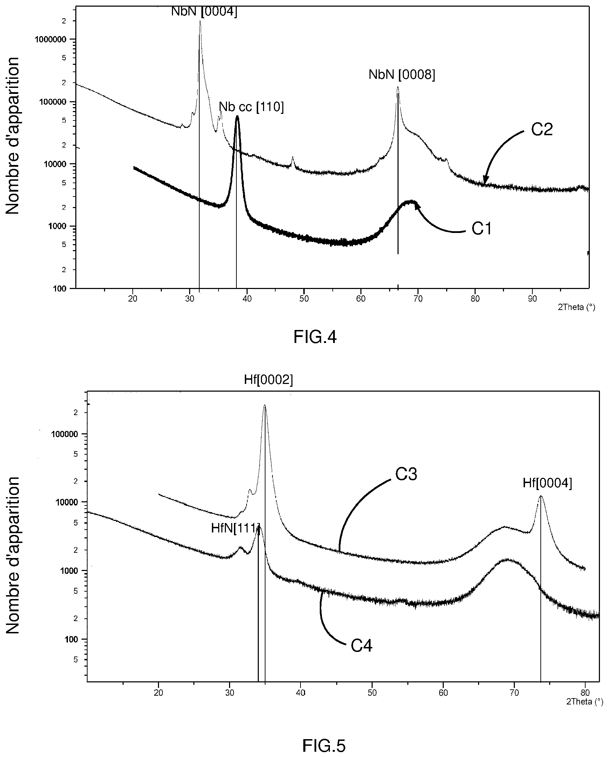

Les figures 4 et 5 illustrent chacune un spectre de diffraction des rayons X permettant d'identifier les phases ou structures cristallographiques en présence. La figure 4 montre que pour la courbe C1 représentative de la structure cristallographique de la couche de métal de transition de type Nb avant nitruration, on a bien une prédominance de l'orientation [110] de la structure cubique centrée (cc) du Nb, et que pour la courbe C2 représentative de la structure cristallographique hexagonale de la couche de métal de transition nitrurée NbN on a bien une prédominance de l'orientation [0004] de la structure hexagonale et de son harmonique d'orientation [0008], c'est-à-dire d'orientation similaire à [0001]. La figure 5 montre que pour la courbe C3 représentative de la structure cristallographique de la couche de métal de transition de type Hf avant nitruration on a bien une prédominance de l'orientation [0002] de la structure hexagonale, et que pour la courbe C4 représentative de la structure cristallographique cubique face centrée (cfc) de la couche de métal de transition nitrurée HfN on a bien une prédominance de l'orientation [111] de la structure cubique face centrée. Sur les figures 3 et 4, seuls les pics ont une importance pour visualiser la prédominance, le reste de la courbe représentant un fond continu dû au dispositif expérimental et à l'échantillon. Des courbes similaires peuvent être réalisées par l'homme du métier pour les autres métaux de transition et les conclusions seraient sensiblement identiques, par exemple pour du nitrure de tantale, on aurait prédominance de l'orientation [111] de la structure cubique face centrée de nitrure de tantale.

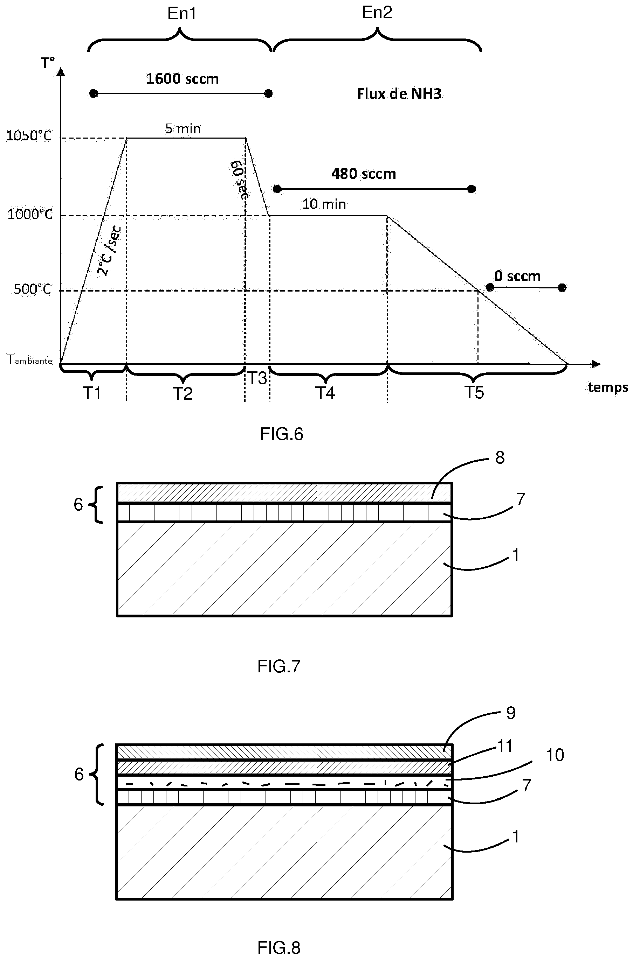

Selon une mise en œuvre particulière du second mode, notamment illustrée à la figure 6, l'étape de nitruration peut comporter une première sous-étape de nitruration En1 réalisée au moins en partie à une première température en imposant une injection d'un gaz de nitruration selon un premier débit, et une deuxième sous-étape de nitruration En2 réalisée au moins en partie à une deuxième température inférieure ou égale à la première température en imposant une injection du gaz de nitruration selon un deuxième débit distinct (ou non, c'est-à-dire que le premier débit peut être égal au deuxième débit) du premier débit. Ceci permet d'optimiser l'orientation cristallographique de la couche de nucléation (couche de métal de transition nitruré). Il va de soi que ces deux sous-étapes de nitruration sont réalisées l'une après l'autre. En particulier, la première sous-étape En1 permet de réaliser une nitruration rapide et la deuxième sous-étape En2 permet de réaliser un recuit stabilisant la phase de nitrure du métal de transition. Consécutivement à ces deux sous-étapes En1 et En2, la couche de métal de transition nitruré est chimiquement et thermiquement stable et peut assurer une fonction de protection du substrat (en particulier si celui-ci est en silicium) pendant la croissance du ou des nanofils.

Le gaz injecté peut être de l'ammoniac (NH₃) ou du diazote (N₂). Le NH₃ est préféré car il permet de nitrurer plus rapidement la couche de métal de transition. En fait, sous la forme NH₃, le pouvoir nitrurant est plus important que pour le N₂. Cette nitruration rapide peut être importante surtout si le métal de transition est susceptible de se transformer en siliciure, ce point est abordé ci-après.

Selon un exemple particulier, le gaz de nitruration injecté étant de l'ammoniac, la première température est comprise entre 1000°C et 1050°C, notamment égale à 1050°C, le premier débit est compris entre 500sccm et 2500 sccm (sccm est une unité de débit issue de l'anglais « standard cubic centimeters per minute », soit des centimètres cube par minute), notamment égal à 1600sccm, la deuxième température est comprise entre 950°C et 1050°C, notamment égale à 1000°C, le deuxième débit est compris entre 500 sccm et 2500 sccm, notamment égal à 500 sccm.

Les débits mentionnés ci-dessus correspondent à la capacité volumique de l'enceinte nitruration utilisée, soit un volume total de gaz (par exemple N₂+NH₃) de 8 litres dans l'exemple mentionné. Pour une enceinte de volume différent, les débits devront être adaptés (par exemple : pour une enceinte de 18 litres, le premier débit devra être notamment égal à 4000 sccm et le deuxième débit notamment égal à 1200 sccm). Autrement dit, le premier débit est compris entre 500*V/8 sccm et 2500*V/8 sccm, notamment égal à 1600*V/8 sccm, et le deuxième débit est compris entre 500*V/8 sccm et 2500*V/8 sccm, notamment égal à 500*V/8 sccm. V est la capacité totale en litre d'une enceinte de nitruration correspondante. Par « enceinte de nitruration correspondante », on entend ici l'enceinte dans laquelle la nitruration de la couche de métal de transition est réalisée.

De manière générale, l'étape de nitruration est réalisée dans une enceinte de nitruration placée à une pression comprise entre 50 mbar et 800 mbar, notamment 100 mbar.

La figure 6 illustre de manière détaillée l'étape de nitruration en représentant l'évolution de la température en fonction du temps dans une enceinte de nitruration. Dans un premier temps T1, la température dans l'enceinte de nitruration monte progressivement, par exemple de 2°C/s jusqu'à atteindre un pallier 1050°C. La première sous-étape de nitruration sous NH₃ En1 visée ci-dessus commence lorsque la température atteint 200°C. Au cours de cette première sous étape, le débit de NH₃ reste constant à 1600 sccm. Dans un deuxième temps T2, concomitant à au moins une partie de la première sous-étape, la température est maintenue à 1050°C pendant un temps compris entre 5 minutes et 15 minutes. Dans un troisième temps T3, la première sous-étape En1 est continuée alors que la température passe de 1050°C à 1000°C en 60s. Dans un quatrième temps T4, la température dans l'enceinte de nitruration est maintenue à 1000°C pendant un temps compris entre 5 minutes et 15 minutes et la deuxième sous-étape En2 est débutée. Dans un cinquième temps T5, l'apport de calories dans l'enceinte de nitruration est stoppé de sorte que l'enceinte de nitruration redescende en température jusqu'à revenir à la température ambiante. La durée de T5 peut correspondre à l'inertie de l'enceinte de nitruration. La deuxième sous-étape de nitruration peut être continuée pendant un temps déterminé au cours du cinquième temps T5. Le cinquième temps T5 peut correspondre à un arrêt du chauffage de l'enceinte puis à sa redescente en température ou peut également correspondre à une étape de croissance des nanofils si l'enceinte utilisée pour la nitruration est aussi l'enceinte de MOCVD dédiée à la synthèse des nanofils.

Selon une mise en œuvre particulière, l'étape de croissance du nanofil 2 est réalisée après la deuxième sous-étape En2 de nitruration, ou est initiée au cours de la deuxième sous-étape En2 de nitruration.

L'utilisation du Ga pour former ledit au moins un nanofil 2 est avantageuse dans le sens où les structures cubiques faces centrées, ou hexagonales de la couche de métal de transition nitruré (donc de la couche de nucléation) sont favorables à une épitaxie du GaN. Des nanofils en nitrure de gallium, dont la structure cristallographique est une structure hexagonale (structure wurtzite) orientée selon l'axe [0001] ou l'axe C de la figure 3, peuvent facilement être nucléés à partir de la couche de nucléation telle que décrite. Alternativement, les nanofils peuvent aussi être réalisés en ZnO, InN ou SiC.

Afin de réaliser une croissance optimisée de nanofil(s), il est préférable que la couche de métal de transition soit peu siliciurée. Le phénomène de siliciuration de la couche de métal de transition peut intervenir, si le substrat est à base de silicium, selon deux cas : au cours de l'étape de dépôt du métal de transition, et/ou lorsque l'on cherche à nitrurer la couche de métal de transition pour délimiter la couche de nucléation. Le premier cas peut s'expliquer de la manière qui va suivre. En fait, à haute température (environ 1000°C), la formation des composés siliciurés MSi₂ est favorisée (M étant le métal de transition utilisé). Parmi ces siliciures, seuls les siliciures des métaux de transition de la colonne V (VSi₂, NbSi₂, TaSi₂), plus le siliciure de Cr (CrSi₂) forment des phases cristallographiques à structure hexagonale, potentiellement intéressantes (si texturées selon l'axe c) pour la croissance de nanofil(s) en nitrure de gallium. Cependant le désaccord de paramètre de maille « a » entre ces phases hexagonales et le nitrure de gallium (3.19 Å) est si important, respectivement de -30%, -36%, -33% et -25% pour le VSi₂, NbSi₂, TaSi₂, CrSi₂, que l'épitaxie du nitrure de gallium est très improbable. Typiquement, le paramètre de maille « a » pour les composés hexagonaux VSi₂, NbSi₂, TaSi₂, CrSi₂, est de respectivement : 4.57 Å, 4.97 Å, 4.78 Å et 4.28 Å. Ainsi, une sous-famille peut être formée des matériaux suivants : Ti, V, Cr, Nb, Ta, Mo, c'est-à-dire des métaux dont le coefficient d'interdiffusion avec le Si est élevé, ce qui implique une cinétique de croissance de la nouvelle phase MSi₂ rapide. A titre d'exemple, le Cr présente un coefficient d'interdiffusion avec le Si à 850°C de 1,5.10-7 cm²/s soit une longueur de diffusion d'environ 11,6 µm en 15 minutes, alors qu'aux alentours des 100°C cette longueur de diffusion descend à environ 80 nm en 15 minutes. Pour les raisons évoquées ci-dessus, si le métal de transition déposé est choisi parmi Cr, V ou Ti, il est préférentiellement déposé à une température inférieure à 100°C afin de de limiter la diffusion du silicium issu du substrat 1. Pour le Nb, la longueur d'interdiffusion Nb-Si pendant 15 minutes est de 12 nm et 2 nm pour respectivement 800°C et 700°C. Le Nb peut donc être déposé à haute température jusqu'à 700-750°C sans -ou avec un très faible- phénomène de siliciuration. Les autres matériaux : Zr, Hf et Ta présentant des coefficients d'interdiffusion avec le Si plus faible que le Nb peuvent donc être aisément déposés depuis la température ambiante jusqu'à 750°C-800°C au plus. Une siliciuration trop importante aurait pour conséquence de ne pas permettre l'obtention plus tard d'une couche de métal de transition nitruré d'épaisseur suffisante. Autrement dit, pour généraliser, le substrat étant en silicium, l'étape de dépôt de la couche de métal de transition est configurée de sorte que l'interdiffusion du silicium dans la couche de métal de transition déposée soit inférieure à 10 nm et/ou de sorte à conserver une tranche de la couche de métal de transition non siliciurée d'au moins 2 nm. En fait, cette tranche non siliciurée est opposée au substrat 1 et est destinée à former la couche de métal de transition nitruré. A la figure 7, la référence 6 indique la couche de métal de transition initialement déposée sur le substrat 1, au cours du dépôt de la couche, une tranche 7 de cette couche 6 peut s'être siliciurée de sorte que seule une partie 8 de la couche 6 est composée du métal de transition pur pouvant servir à former, par nitruration, la couche de nucléation. Dans le deuxième cas, l'étape de nitruration peut nécessiter de travailler à 1050°C pendant quelques minutes. Pour cela, on préfèrera utiliser comme gaz nitrurant du NH₃ car grâce à son haut pouvoir nitrurant, la vitesse de réaction de nitruration est supérieure à celle de la siliciuration. En fait, dans l'idéal, on cherche à former au cours de l'étape de nitruration au moins une couche de métal de transition nitruré 9 (figure 8) dans la couche de métal de transition 6 déposée, l'épaisseur de ladite couche de métal nitruré 9 étant comprise avantageusement entre 2 nm et 50 nm. Afin de limiter l'obtention d'un nouveau composé siliciuré, on optimisera l'étape de nitruration. En fait, après l'étape de nitruration, on comprend, comme illustré à la figure 8, que la couche que l'on cherchait à réaliser en déposant un métal de transition 6 peut comporter une première couche de métal de transition siliciuré 7 obtenue au cours du dépôt dudit métal de transition, une deuxième couche de métal de transition siliciuré 10 disposée dans la continuité de la première couche de métal de transition siliciuré 7 et la couche de nucléation 9 issue de la nitruration de la couche 8 de la figure 7. Optionnellement, il est aussi possible qu'il reste une couche 11 résiduelle de métal de transition pur intercalée entre la couche 9 et la couche 10, ceci dépendant au moins en partie de l'épaisseur déposée de la couche de métal de transition.

Il résulte de l'explication des premier et deuxième cas, que si le substrat 1 est en silicium, l'homme du métier sera apte à déterminer l'épaisseur de la couche de métal de transition à déposer en fonction du type de métal de transition à déposer, de la température de dépôt du métal de transition, de la durée de l'étape de dépôt du métal de transition, ainsi que de la durée de l'étape de nitruration afin qu'il soit possible d'obtenir une couche d'une épaisseur prédéterminée de métal de transition nitruré. Autrement dit, le substrat 1 étant à base de silicium, l'étape de dépôt de la couche de métal de transition 6 peut comprendre une étape préalable de détermination de l'épaisseur de la couche de métal de transition 6 à déposer, ladite étape de détermination de l'épaisseur comprenant : une étape de détermination d'une première longueur de diffusion du silicium dans la couche de métal de transition 6 au cours du futur dépôt de la couche de métal de transition en fonction du métal de transition utilisé et de la température de dépôt ; une étape de détermination d'une deuxième longueur de diffusion du silicium dans la couche de métal de transition 6 au cours de la future étape de nitruration de la couche de métal de transition 6. Ladite épaisseur de la couche de métal de transition 6 à déposer étant fonction de l'épaisseur désirée de la couche de métal de transition nitruré et d'une épaisseur d'une tranche de métal de transition siliciuré obtenue dans la future couche de métal de transition 6 à partir des première et deuxième longueurs de diffusion déterminées.

De préférence, la structure cristallographie prédominante du substrat 1 est d'orientation [100] au moins au niveau de l'interface entre le substrat 1 et la couche de métal de transition 6. Ceci permet notamment de diminuer les coûts de fabrication.

De manière générale, le substrat 1 sera avantageusement préparé avant le dépôt de la couche de métal de transition 6. Pour cela, le procédé peut comporter, avant l'étape de dépôt de la couche de métal de transition 6, une étape de désoxydation d'une surface du substrat 1 destinée à recevoir le dépôt de la couche de métal de transition 6. Plus particulièrement, cette étape de désoxydation de la surface du silicium peut être réalisée soit par voie chimique (bain HF) soit par voie physique (« etch » de la surface en appliquant une tension bias sur le substrat 1). Ceci permet notamment de retirer la couche d'oxyde natif de silice (SiO2) qui est une barrière 'isolante' à l'injection des électrons dans la couche de nucléation et dans le nanofil de nitrure de gallium.

De manière préférentielle, le procédé de croissance décrit ci-avant dans ses différents modes de réalisation peut être utilisé dans le cadre de la formation d'un dispositif tel que décrit précédemment.

Ainsi, l'invention peut aussi être relative à un procédé de fabrication d'un dispositif, par exemple tel que décrit ci-avant, comportant une étape de mise en œuvre du procédé de croissance tel qu'il a été décrit ci-avant, notamment dans ses différentes mises en œuvre ou réalisations.

Par ailleurs, le procédé de fabrication peut comporter en outre une étape de dopage électrique d'un premier type d'au moins une extrémité 2b du nanofil 2 opposée au substrat 1. Ce premier type est, de préférence, un dopage de type n. En outre, le procédé comporte aussi une étape de formation d'un élément 5 dopé électriquement d'un deuxième type opposé au premier type au niveau de l'extrémité 2b du nanofil 2 opposée au substrat 1. Ce deuxième type de dopage est préférentiellement de type p. Ainsi, l'extrémité 2b du nanofil 2 et l'élément 5 dopé associé à cette extrémité 2b peuvent former une jonction d'une diode destinée à émettre de la lumière. Cette jonction est, de préférence, une homojonction, c'est-à-dire que le nanofil 2 et l'élément 5 dopé associé sont à base de mêmes matériaux comme par exemple le nitrure de gallium. La réalisation d'une hétérojonction est aussi possible, par exemple on peut utiliser le ZnO sous forme de nanofil dopé n, puis ajouter des puits quantiques à base de ZnO et utiliser l'élément 9 en GaN dopé électriquement p. En fait, il est actuellement difficile de doper p le ZnO.

Le procédé de fabrication peut en outre comporter une étape de formation de puits quantiques disposés au niveau de l'interface entre le nanofil 2 et l'élément 5 dopé électriquement du deuxième type.

Selon une alternative à la réalisation de la figure 6, l'étape de nitruration comporte une première sous-étape de nitruration En1 réalisée au moins en partie à une première température en imposant une injection d'un gaz de nitruration selon un premier débit, une deuxième sous-étape de nitruration En2 réalisée au moins en partie à une deuxième température supérieure ou égale à la première température en imposant une injection du gaz de nitruration selon un deuxième débit distinct, ou non (c'est-à-dire que le premier débit peut être égal au deuxième débit), du premier débit.

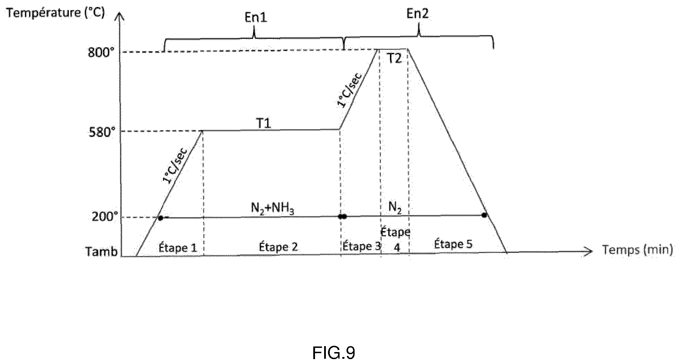

Cette alternative de la figure 6 est illustrée à la figure 9. Ainsi, sur la figure 9, la température T1 est comprise entre 400°C et 1050°C (ou 1400°C), notamment entre 500°C et 800°C, et de façon préférentielle égale à 600°C.

La première sous-étape En1 est découpée par souci de clarté en deux étapes : étape 1 et étape 2.

Dans l'étape 1 de la figure 9, on observe une montée en température jusqu'à T1 (c'est-à-dire la première température)._Les gaz porteurs sont N₂, N₂+H₂, ou H₂, de façon préférentielle N₂. Le gaz de nitruration injecté peut être de l'ammoniac (NH₃) et l'injection peut commencer pour une température comprise entre Tamb (représentative de la température ambiante) et T1 ; notamment dès 200°C. La rampe de montée en température de Tamb jusqu'à T1 est supérieure à 1°C/min, et notamment égale à 1°C/sec. Au cours de cette étape 1, le débit d'ammoniac peut être compris entre 10×V/18 sccm et 4000×V/18 sccm, notamment égal à 1200×V/18 sccm (où V est le volume de l'enceinte en litres). De manière générale, le ratio des flux d'ammoniac sur azote (NH₃/N₂) peut être compris entre 0.0005% et 100%, de préférence entre 0,0055% et 22%, notamment égal à 6.6%.

Dans l'étape 2 de la figure 9, il est réalisé un recuit à T1. Les gaz porteurs sont N₂, N₂+H₂, ou H2, de façon préférentielle N₂. Le gaz de nitruration injecté peut être de l'ammoniac (NH₃). Le débit d'ammoniac peut être compris entre 10×V/18 sccm et 4000×V/18 sccm, notamment égal à 1200×V/18 sccm (où V est le volume de l'enceinte en litres). De manière générale, le ratio des flux d'ammoniac sur azote (NH₃/N₂) peut être compris entre 0.0005% et 100%, de préférence entre 0,0055% et 22%, notamment égal à 6.6%. De préférence, le temps de recuit sous NH₃ supérieur à 1 seconde, notamment compris entre 5 minutes et 30 minutes.

La deuxième sous-étape En2 est découpée par souci de clarté en trois étapes : étape 3, étape 4 et étape 5. De préférence, la deuxième température T2 est comprise entre 400°C et 1050°C (ou 1400°C), notamment entre 500°C et 1000°C, et de façon préférentielle égale à 800°C. A l'étape 3 (si T1≠T2 sinon on passe directement à l'étape 4) on a une montée en température jusqu'à T2. Les gaz porteurs sont N₂, N₂+H₂, ou H₂, de façon préférentielle N₂. Le gaz de nitruration injecté peut être de l'ammoniac (NH₃). La rampe de montée en température de T1 jusqu'à T2 est supérieure à 1°C/min et notamment égale à 1°C/sec. Le débit d'ammoniac peut être compris entre 10×V/18 sccm et 4000×V/18 sccm, notamment égal à 1200×V/18 sccm (où V est le volume de l'enceinte en litres). De manière générale, le ratio des flux d'ammoniac sur azote (NH₃/N₂) peut être compris entre 0.0005% et 100%, de préférence entre 0,0055% et 22%, notamment égal à 6.6%.

A l'étape 4, il est effectué un recuit à T2._Les gaz porteurs sont N₂, N₂+H₂, ou H₂, de façon préférentielle N₂. Le gaz de nitruration injecté peut être de l'ammoniac (NH₃). Le débit d'ammoniac peut être compris entre 10×V/18 sccm et 4000×V/18 sccm, notamment égal à 1200×V/18 sccm (où V est le volume de l'enceinte en litres). De manière générale, le ratio des flux d'ammoniac sur azote (NH₃/N₂) peut être compris entre 0.0005% et 100%, de préférence entre 0,0055% et 22%, notamment égal à 6.6%. Le temps de recuit sous NH₃ est supérieur à 1 seconde, notamment compris entre 1 et 30 minutes.

A l'étape 5, on effectue une redescente en température._Les gaz porteurs sont N₂, N₂+H₂, ou H₂, de façon préférentielle N₂. Le gaz de nitruration injecté peut être de l'ammoniac (NH₃). La rampe de descente en température de T2 jusqu'à Tamb est supérieure à 1°C/min et notamment égale à 1°C/sec. Le débit d'ammoniac peut être compris entre 10×V/18 sccm et 4000×V/18 sccm, notamment égal à 1200×V/18 sccm (où V est le volume de l'enceinte en litres). De manière générale, le ratio des flux d'ammoniac sur azote (NH₃/N₂) peut être compris entre 0.0005% et 100%, de préférence entre 0,0055% et 22%, notamment égal à 6.6%.

Concernant cette alternative de la figure 9, l'étape de nitruration peut aussi être réalisée dans une enceinte de nitruration placée à une pression comprise entre 50 mbar et 800 mbar, notamment 100 mbar, et l'étape de croissance du nanofil (2) peut être réalisée après la deuxième sous-étape de nitruration (En2), ou est initiée au cours de la deuxième sous-étape de nitruration (En2).

Les étapes associées à la figure 6 sont préférablement mises en œuvre lorsque le métal de transition est le Ta (dans ce cas la première température est préférentiellement supérieure à la deuxième température lors de l'étape de nitruration). En effet, pour ce matériau on obtient une amélioration notable de la qualité des nanofils obtenus (verticalité, homogénéité de forme) par rapport à la variante de la figure 9. Inversement, et pour les même raisons, la variante de la figure 9 s'applique tout particulièrement lorsque l'on cherche à nitrurer le métal de transition de type : Zr, Hf, Nb (dans ce cas la première température est préférentiellement inférieure à la deuxième température lors de l'étape de nitruration).

## Revendications

1. Dispositif électronique comprenant un substrat (1), au moins un nanofil (2) semi-conducteur et une couche tampon (3) interposée entre le substrat (1) et ledit nanofil (2), **caractérisé en ce que** la couche tampon (3) est formée au moins en partie par une couche de métal de transition nitruré (9) à partir de laquelle s'étend le nanofil (2), ledit métal de transition nitruré étant choisi parmi : le nitrure de chrome, le nitrure de zirconium, le nitrure de niobium, le nitrure de molybdène, le nitrure de hafnium, ou le nitrure de tantale et **en ce que** la couche tampon (3) est électriquement conductrice de sorte à permettre un contact électrique entre au moins une partie électriquement conductrice du substrat (1) et le nanofil (2), et **caractérisé en ce que** la couche de métal de transition nitruré (9) est un composé stoechiométrique métal de transition - azote remplissant les conditions suivantes :
- le composé stoechiométrique présente une structure cristallographique favorable à l'épitaxie du nitrure de gallium, notamment une structure cristallographique cubique face centrée ou hexagonale,
- une tolérance ΔN par rapport à la concentration en azote inférieure ou égale à 10%.

2. Dispositif selon la revendication précédente, **caractérisé en ce que** la couche de métal de transition nitruré (9) est un composé stoechiométrique métal de transition - azote remplissant la condition suivante :
le composé stoechiométrique présente une proportion de métal de transition comprise entre 50% et inférieure à 100%.

3. Dispositif selon l'une quelconque des revendications précédentes, **caractérisé en ce que** la structure cristallographique de la couche de métal de transition est au moins en partie cubique face centrée, notamment orientée [111], ou hexagonale, notamment orientée [0001] ou selon la direction d'axe 'C', associée à la couche de métal de transition nitruré.

4. Dispositif selon l'une quelconque des revendications précédentes, **caractérisé en ce que** l'extrémité (2b) du nanofil (2) distante du substrat (1) est dopée électriquement selon un premier type, et **en ce qu'**il comporte un élément électriquement conducteur dopé d'un second type disposé au niveau de l'extrémité (2b) du nanofil (2) distante du substrat (1) de sorte à former une jonction électrique, notamment une jonction de diode électroluminescente.

5. Dispositif selon l'une quelconque des revendications précédentes, **caractérisé en ce qu'**il comporte un élément de polarisation du nanofil (2) de sorte à permettre la génération d'une onde lumineuse au niveau dudit nanofil (2).

6. Dispositif selon l'une quelconque des revendications précédentes **caractérisé en ce que** le substrat (1) est en silicium, et **en ce que** la couche de métal de transition est configurée de sorte que l'interdiffusion du silicium dans la couche de métal de transition déposée soit inférieure à 10 nm et/ou de sorte à conserver une tranche de la couche de métal de transition non siliciurée d'au moins 2 nm.

7. Procédé de croissance d'au moins un nanofil semi-conducteur (2) comportant une étape de réalisation, au niveau d'un substrat (1), d'une couche tampon (3) formée au moins en partie par une couche de nucléation (9) pour la croissance du nanofil (2) et une étape de croissance du nanofil (2) à partir de la couche de nucléation, **caractérisé en ce que** la couche de nucléation est formée par une couche de métal de transition nitruré (9) choisi parmi : le nitrure de vanadium, le nitrure de chrome, le nitrure de zirconium, le nitrure de niobium, le nitrure de molybdène, le nitrure de hafnium, ou le nitrure de tantale, et **en ce que** la couche tampon (3) est électriquement conductrice de sorte à permettre un contact électrique entre au moins une partie électriquement conductrice du substrat (1) et le nanofil (2).

8. Procédé selon la revendication précédente, **caractérisée en ce que** la couche tampon (3) est déposée en phase vapeur à partir d'un mélange gazeux comprenant de l'azote et un métal de transition choisi parmi le vanadium, le chrome, le zirconium, le niobium, le molybdène, le hafnium, ou le tantale, notamment le dépôt de la couche tampon (3) est réalisé à une température comprise entre la température ambiante et 400°C.

9. Procédé selon la revendication 7, **caractérisé en ce que** la couche tampon (3) est réalisée à partir des étapes suivantes :
- le dépôt sur le substrat (1) d'une couche d'un métal de transition (6) choisi parmi le vanadium, le chrome, le zirconium, le niobium, le molybdène, le hafnium, ou le tantale, notamment le dépôt de la couche de métal de transition est réalisé à une température comprise entre la température ambiante et 400°C,
- la nitruration d'au moins une partie (9) de la couche de métal de transition déposée (6) de sorte à former la couche de métal de transition nitruré (9) présentant une surface destinée à la croissance du nanofil (2).

10. Procédé selon l'une quelconque des revendications 7 à 9, **caractérisé en ce que** la couche de métal de transition nitruré (9) est réalisée de sorte à former un composé stoechiométrique métal de transition-azote remplissant les conditions suivantes :
- le composé stoechiométrique présente une proportion de métal de transition comprise entre 50% et inférieure à 100%,
- le composé stoechiométrique présente une structure cristallographique favorable à l'épitaxie du GaN, notamment une structure cristallographique cubique face centrée ou hexagonale,
- une tolérance ΔN par rapport à la concentration en azote inférieure ou égale à 10%.

11. Procédé selon la revendication 9, ou les revendications 9 et 10, **caractérisé en ce que** l'étape de nitruration de ladite au moins une partie de la couche de métal de transition (6) est réalisée de sorte à modifier au moins en partie la structure cristallographique de la couche de métal de transition vers une structure cristallographique cubique face centrée, ou hexagonale, associée à la couche de métal de transition nitruré.

12. Procédé selon la revendication 9, ou la revendication 9 et l'une quelconque des revendications 10 à 11, **caractérisé en ce que** l'étape de nitruration comporte :
- une première sous-étape de nitruration (En1) réalisée au moins en partie à une première température en imposant une injection d'un gaz de nitruration selon un premier débit,
- une deuxième sous-étape de nitruration (En2) réalisée au moins en partie à une deuxième température inférieure ou égale à la première température en imposant une injection du gaz de nitruration selon un deuxième débit distinct, ou non, du premier débit.

13. Procédé selon la revendication précédente, **caractérisé en ce que** le gaz de nitruration injecté est de l'ammoniac, et **en ce que** :
- la première température est comprise entre 1000°C et 1050°C, notamment égale à 1050°C,
- le premier débit est compris entre 500*V/8 sccm et 2500*V/8 sccm, notamment égal à 1600*V/8 sccm,
- la deuxième température est comprise entre 950°C et 1050°C, notamment égale à 1000°C,
- le deuxième débit est compris entre 500*V/8 sccm et 2500*V/8 sccm, notamment égal à 500*V/8 sccm
où V est la capacité totale en litre d'une enceinte de nitruration correspondante.

14. Procédé selon la revendication 9, ou la revendication 9 et l'une quelconque des revendications 10 à 11, **caractérisé en ce que** l'étape de nitruration comporte :
- une première sous-étape de nitruration (En1) réalisée au moins en partie à une première température en imposant une injection d'un gaz de nitruration selon un premier débit,
- une deuxième sous-étape de nitruration (En2) réalisée au moins en partie à une deuxième température supérieure ou égale à la première température en imposant une injection du gaz de nitruration selon un deuxième débit distinct, ou non, du premier débit.

15. Procédé selon l'une des revendications 12, 13 ou 14, **caractérisé en ce que** l'étape de nitruration est réalisée dans une enceinte de nitruration placée à une pression comprise entre 50 mbar et 800 mbar, notamment 100 mbar.

16. Procédé selon l'une quelconque des revendications 12, 13, 14, ou 15, **caractérisé en ce que** l'étape de croissance du nanofil (2) est réalisée après la deuxième sous-étape de nitruration (En2), ou est initiée au cours de la deuxième sous-étape de nitruration (En2).

17. Procédé selon la revendication 9, ou la revendication 9 et l'une quelconque des revendications 10 à 16, **caractérisé en ce que** le substrat (1) étant en silicium, l'étape de dépôt de la couche de métal de transition (6) est configurée de sorte que l'interdiffusion du silicium dans la couche de métal de transition déposée soit inférieure à 10 nm et/ou de sorte à conserver une tranche de la couche de métal de transition non siliciurée d'au moins 2 nm.

18. Procédé selon la revendication 9, ou la revendication 9 et l'une quelconque des revendications 10 à 17, **caractérisé en ce que** le métal de transition déposé étant choisi parmi Cr ou V, ledit métal de transition est déposé à une température inférieure à 100°C.

19. Procédé selon la revendication 9, ou la revendication 9 et l'une quelconque des revendications 10 à 18, **caractérisé en ce que**, le substrat (1) étant à base de silicium, l'étape de dépôt de la couche de métal de transition (6) comprend une étape préalable de détermination de l'épaisseur de la couche de métal de transition (6) à déposer comprenant :
- une étape de détermination d'une première longueur de diffusion du silicium dans la couche de métal de transition (6) au cours du futur dépôt de la couche de métal de transition en fonction du métal de transition utilisé et de la température de dépôt,
- une étape de détermination d'une deuxième longueur de diffusion du silicium dans la couche de métal de transition (6) au cours de la future étape de nitruration de la couche de métal de transition (6),ladite épaisseur de la couche de métal de transition (6) à déposer étant fonction de l'épaisseur désirée de la couche de métal de transition nitruré et d'une épaisseur d'une tranche de métal de transition siliciuré obtenue dans la future couche de métal de transition (6) à partir des première et deuxième longueurs de diffusion déterminées.

20. Procédé de fabrication d'un dispositif selon l'une quelconque des revendications 1 à 6, **caractérisé en ce qu'**il comporte une étape de mise en œuvre du procédé de croissance selon l'une des revendications 7 à 19.

21. Procédé selon la revendication précédente, **caractérisé en ce qu'**il comporte les étapes suivantes :
- le dopage électrique d'un premier type d'au moins une extrémité (2b) du nanofil (2) opposée au substrat (1),
- la formation d'un élément (5) dopé électriquement d'un deuxième type opposé au premier type au niveau de l'extrémité (2b) du nanofil (2) opposée au substrat (1).
